# EUROPEAN PATENT APPLICATION

(11) **EP 0 521 765 A2**
(43) Date of publication of application: **07.01.1993**
(21) Application number: 92401841.9
(22) Date of filing: 29.06.1992
(51) Int. Cl.: H01L 39/22, H01L 39/24

(54) **Method for manufacturing superconducting device having a superconducting layer formed of an oxide superconductor and a nonsuperconducting layer formed on the superconducting layer**

(30) Priority: 02.07.1991 JP 188074/91
(71) Applicant: Sumitomo Electric Industries, Ltd., Osaka 541 (JP)
(72) Inventor: Tanaka, So, F-75116 Paris (FR); Iiyama, Michitomo, F-75116 Paris (FR)
(74) Representative: Ballot, Paul Denis Jacques

(57) **Abstract**

For manufacturing a superconducting device, a *c*-axis orientated oxide superconductor layer is formed on a surface of the substrate and at least one layer which is not composed of an oxide superconductor is formed on the *c*-axis orientated oxide superconductor layer. The *c*-axis orientated oxide superconductor layer is etched so that at least one side surface of the *c*-axis orientated oxide superconductor layer exposed. Then, the substrate is heated in an O₂ atmosphere, an O₂ atmosphere including O₃ or an O₃ atmosphere, so that oxygen penetrates into the *c*-axis orientated oxide superconductor layer from the exposed side surface. An *a*-axis orientated oxide superconductor thin film is formed so as to cover the exposed side surface of the *c*-axis orientated oxide superconductor layer.

## Description

### Background of the Invention

### Field of the invention

The present invention relates to a method for manufacturing a superconducting device, and more specifically to a method for manufacturing a superconducting device having a superconducting layer formed of an oxide superconductor thin film and a nonsuperconducting layer, such as an insulating layer, a normal conducting layer or a semiconductor layer, formed on the superconducting layer.

### Description of related art

In order to produce superconducting devices which utilize an oxide superconductor, it is necessary to form an oxide superconductor thin film. For example, in order to prepare a tunnel type Josephson device which has SIS (superconductor-insulator-superconductor) junction, it is necessary to form a stacked structure which includes a first oxide superconductor thin film, an insulator thin film stacked on the first oxide superconductor thin film and a second oxide superconductor thin film stacked on the insulator film. Thickness of the insulator thin film of this SIS junction is determined by coherence length of the superconductor. Since an oxide superconductor has extremely short coherence length, the thickness of the insulator thin film of an SIS junction which utilizes an oxide superconductor should be about few nanometers.

On the other hand, crystallinity of the thin films which forms the stacked structure is important for the device properties. Therefore, the thin films are required to be good crystalline, rather single crystalline. If the SIS junction has a multi-crystal thin film or an amorphous thin film, the Josephson device does not have stable properties.

Crystallinity of the thin films are also important for a superconducting transistor which includes an oxide superconductor thin film and a semiconductor thin film.

Since an oxide superconductor is degraded by the atmosphere, a surface portion of a thickness of one nanometer of an oxide superconductor thin film loses its superconductivity and the crystallinity of the portion decreases in the air.

In case of stacking a nonsuperconducting thin film, for example, an insulator thin film, a normal conductor thin film, a semiconductor thin film etc., on an oxide superconductor thin film, the method for preparing the nonsuperconducting thin film is different from the method for preparing the superconductor thin film. Naturally, film-preparing apparatuses for the oxide superconductor thin film and for the nonsuperconducting thin film are different each other. Therefore, the oxide superconductor thin film can not avoid contact with the air while the movement to the film-preparing apparatus for the nonsuperconducting thin film.

In the prior art, in order to restore the crystallinity of the surface of the oxide superconductor thin film, the oxide superconductor thin film is heated to about 700°C in a high vacuum of about 1x10⁻⁹ Torr. This heat-treatment restores the crystallinity of the surface portion of the oxide superconductor thin film. A nonsuperconducting thin film which is stacked on this heat-treated oxide superconductor thin film grows epitaxially.

However, oxygen of the oxide superconductor crystals escapes while the heat-treatment so that the superconducting properties of the oxide superconductor thin film decrease or the oxide superconductor thin film loses its superconductivity.

On the contrary, superconducting properties of the oxide superconductor thin film does not deteriorate, when the oxide superconductor thin film is heated under O₂ atmosphere. However, the crystallinity of the surface of the oxide superconductor thin film is not restored by the heat-treatment in O₂ atmosphere.

In order to solve the above problem, the oxide superconductor thin film which has been heated under high vacuum is heated in oxygen or ozone after a nonsuperconducting thin film is stacked on it. Though this process restores crystallinity and superconducting properties of the oxide superconducting thin film, oxygen of the oxide superconductor crystals escapes when the oxide superconducting thin film is heated in a successive process.

### Summary of the Invention

Accordingly, it is an object of the present invention to provide a method for manufacturing a superconducting device, which have overcome the above mentioned defects of the conventional ones.

Another object of the present invention is to provide a method for manufacturing a Josephson device, which have overcome the above mentioned defects of the conventional ones.

The above and other objects of the present invention are achieved in accordance with the present invention by a method for manufacturing a superconducting device, the method comprising the step of forming on a surface of the substrate a *c*-axis orientated oxide superconductor layer, heating the substrate under high vacuum so as to improve crystallinity of the surface of the *c*-axis orientated oxide superconductor layer, forming on the *c*-axis orientated oxide superconductor layer at least one layer which is not composed of an oxide superconductor, etching the *c*-axis orientated oxide superconductor layer, so that at least one side surface of the *c*-axis orientated oxide superconductor layer exposed, heating the substrate in an O₂ atmosphere, an O₂ atmosphere including O₃ or an O₃ atmosphere, so that oxygen penetrates into the *c*-axis orientated oxide superconductor layer from the exposed side surface, and forming an *a*-axis orientated oxide superconductor thin film so as to cover the exposed side surface of the *c*-axis orientated oxide superconductor layer.

According to another aspect of the present invention, there is provided a method for manufacturing a Josephson device, the method comprising the step of forming on a surface of the substrate a first *c*-axis orientated oxide superconductor layer, heating the substrate under high vacuum so as to improve crystallinity of the surface of the first *c*-axis orientated oxide superconductor layer, forming on the *c*-axis orientated oxide superconductor layer a insulator layer, forming on the insulator layer a second *c*-axis orientated oxide superconductor layer, etching the first and second *c*-axis orientated oxide superconductor layer and the insulator layer, so that two opposite side surfaces of the first *c*-axis orientated oxide superconductor layer exposed, heating the substrate in an O₂ atmosphere, an O₂ atmosphere including O₃ or an O₃ atmosphere, so that oxygen penetrates into the first *c*-axis orientated oxide superconductor layer from the exposed side surface, and forming an *a*-axis orientated oxide superconductor thin film so as to cover the exposed side surfaces of the first and second *c*-axis orientated oxide superconductor layer and the insulator layer.

The method in accordance with the present invention is effective to restore superconducting properties of the oxide superconductor layer on which another layer is stacked and of which the superconducting properties are decreased by loss of oxygen of the crystals of the superconductor.

In a preferred embodiment, the side surface of the *c*-axis orientated oxide superconductor layer, which is exposed by the etching process is parallel to the *c*-axis of the crystal of the oxide superconductor which composes the *c*-axis orientated oxide superconductor layer. Since the oxygen penetrates oxide superconductor and migrates in oxide superconductor along a direction perpendicular to the *c*-axis of crystal of oxide superconductor easier.

Preferably, the *c*-axis orientated oxide superconductor layer is etched so that two opposite side surfaces of the *c*-axis orientated oxide superconductor layer are exposed. For the enough supply of oxygen to inside portions of the *c*-axis orientated oxide superconductor layer, the distance between the two opposite side surfaces of the *c*-axis orientated oxide superconductor layer is preferably less than about 3 µm.

In a preferred embodiment, the substrate is heated at temperatures ranging from 400 to 500°C in an O₂ atmosphere, an O₂ atmosphere including O₃ or an O₃ atmosphere. At temperatures below 400°C, insufficient oxygen penetrates into the *c*-axis orientated oxide superconductor layer. At temperatures above 500°C, unfavorable diffusion is occurred between adjacent layers.

In case of an O₂ atmosphere, partial pressure of O₂ is preferably selected in a range of 5 to 100 Torr, and in case of an O₃ atmosphere, partial pressure of O₃ is preferably selected in a range of 0.1 to 10 Torr.

In this connection, temperature of the substrate determines partial pressures of O₂ and O₃. When the substrate is heated at a temperature of 400°C in an O₂ atmosphere, partial pressure of O₂ is, preferably, 5 to 20 Torr. However, when the substrate is heated at a temperature of 500°C in an O₂ atmosphere, necessary partial pressure of O₂ is 10 to 100 Torr for sufficient oxidation.

Similarly, when the substrate is heated at a temperature of 400°C in an O₃ atmosphere, partial pressure of O₃ is preferably 0.1 to 1 Torr and when the substrate is heated at a temperature of 500°C in an O₃ atmosphere, necessary partial pressure of O₃ is 0.2 to 10 Torr.

In accordance with the present invention, the *c*-axis orientated oxide superconductor layer is covered with an *a*-axis orientated oxide superconductor thin film. Preferably, this *a*-axis orientated oxide superconductor thin film has a thickness of ranging 10 to 50 nanometers. Since oxygen of oxide superconductor crystals migrates to a direction perpendicular to *c*-axes of the oxide superconductor crystals, and little oxygen migrates to a direction parallel to *c*-axes of the oxide superconductor crystals. Therefore, oxygen of oxide superconductor crystals of the *c*-axis orientated oxide superconductor layer does not penetrate the *a*-axis orientated oxide superconductor thin film so that enough oxygen remains in the *c*-axis orientated oxide superconductor layer. The *a*-axis orientated oxide superconductor thin film prevents the *c*-axis orientated oxide superconductor layer from contamination.

In addition, oxide superconductor tends to deform along the *c*-axes of the oxide superconductor crystals. Therefore, strains caused by difference in thermal coefficient between the *c*-axis orientated oxide superconductor layer and the layer stacked on the *c*-axis orientated oxide superconductor layer is absorbed by the *a*-axis orientated oxide superconductor thin film.

When the *a*-axis orientated oxide superconductor thin film is formed by using Y-Ba-Cu-O oxide superconductor, the substrate is heated at a temperatue of about 650°C. Therefore, the substrate is preferably heated to a temperatue of about 650°C, after the heat-treatment by which oxygen penetrates into the *c*-axis orientated oxide superconductor layer, and the *a*-axis orientated oxide superconductor thin film is formed successively.

It is desired that the abovementioned oxide superconductor is a high-T_{c} (high critical temperature) oxide superconductor. This high-T_{c} oxide superconductor has been studied by many researchers since the discovery of Bednorz and Müller in 1986, and is said to indicate oxide superconductor having a critical temperature of not less than 30K. More specifically, the oxide super conductor is a high-T_{c} copper-oxide type compound oxide superconductor including a Y-Ba-Cu-O type compound oxide superconductor, a Bi-Sr-Ca-Cu-O type compound oxide superconductor and a Tl-Ba-Ca-Cu-O type compound oxide superconductor.

In addition, the substrate, on which the oxide superconductor layer is deposited, can be formed of an insulating substrate, preferably an oxide single crystalline substrate such as MgO, SrTiO₃, CdNdA1O₄, etc. These substrate materials are very effective in forming or growing a crystalline film having a high orientation property. However, the superconducting device can be formed on a semiconductor substrate if an appropriate buffer layer is deposited thereon. For example, the buffer layer on the semiconductor substrate can be formed of a double-layer coating formed of a MgA1O₄ layer and a BaTiO₃ layer if silicon is used as a substrate.

As seen from the above, the superconducting device manufactured in accordance with the present invention includes a *c*-axis orientated oxide superconductor layer of which the superconducting properties are kept excellent. Therefore, the superconducting device manufactured in accordance with the present invention has high performance.

The above and other objects, features and advantages of the present invention will be apparent from the following description of preferred embodiments of the invention with reference to the accompanying drawings.

### Brief Description of the Drawings

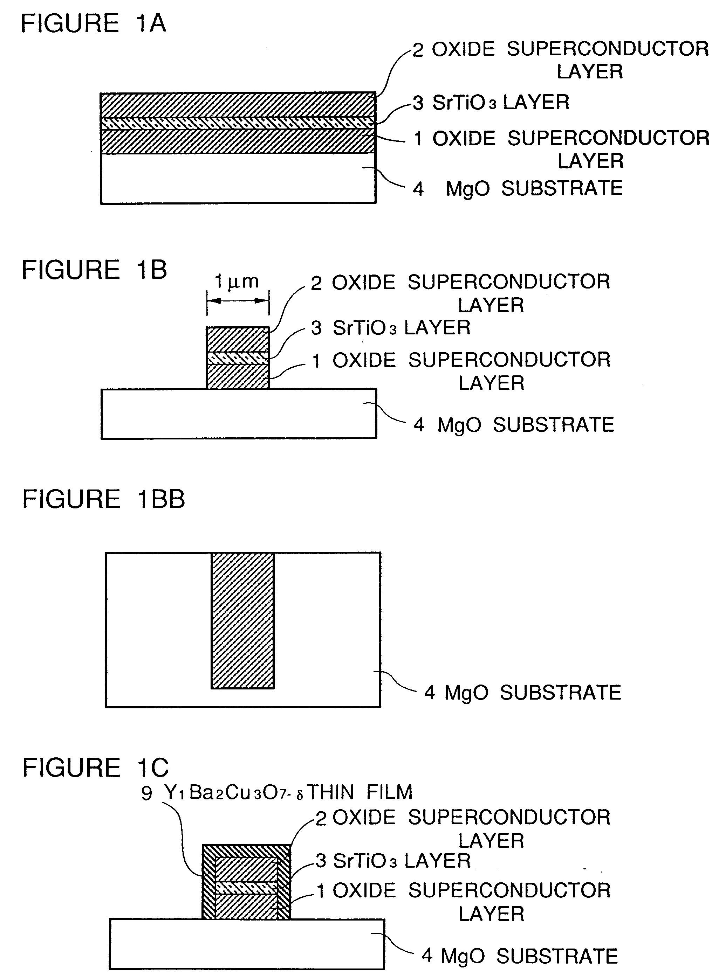

Figures 1A to 1H are diagrammatic sectional views for illustrating a first embodiment of the process in accordance with the present invention for manufacturing the tunnel type Josephson device; and

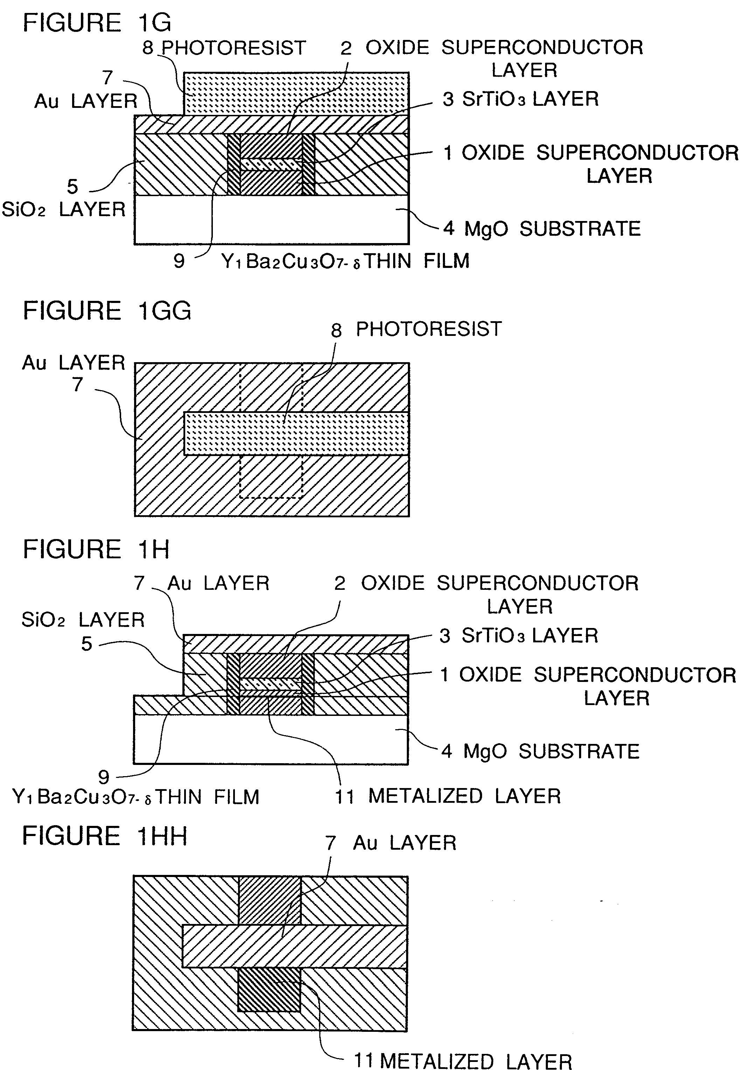

Figures 1BB, 1GG and 1HH are respectively diagrammatic plane views of Figures 1B, 1G and 1H.

### Description of the Preferred embodiments

Referring to Figures 1A to 1H, the process in accordance with the present invention for manufacturing the tunnel type Josephson device will be described.

As shown in Figure 1A, a stacked structure consisting of an oxide superconductor layer 1, an SrTiO₃ layer 3 stacked on the oxide superconductor layer 1 and a oxide superconductor layer 2 stacked on the SrTiO₃ layer 3 was formed on an MgO (100) substrate 4. This stacked structure was formed by the following way.

At first, a *c*-axis orientated Yi₁Ba₂Cu₃O_{7-δ} oxide superconductor thin film having a thickness of 400 nanometers, which would be the oxide superconductor layer 1 was deposited on the (100) surface of the MgO substrate 4 by for example an off-axis sputtering process. This *c*-axis orientated Y₁Ba₂Cu₃O_{7-δ} oxide superconductor thin film may be deposited by a reactive evaporation, an MBE (molecular beam epitaxy), a CVD, etc. The condition of forming the *c*-axis orientated Y₁Ba₂Cu₃O_{7-δ} oxide superconductor thin film by off-axis sputtering was as follows:
- Sputtering Gas: Ar: 90%
O₂: 10%
- Total pressure: 5 x 10⁻² Torr
- Temperature of the substrate: 700°C

The oxide superconductor thin film is preferably formed of a high-T_{c} (high critical temperature) oxide superconductor material, particularly a high-T_{c} copper-oxide type compound oxide superconductor material, for example, a Bi-Sr-Ca-Cu-O type compound oxide superconductor material, or a Tl-Ba-Ca-Cu-O type compound oxide superconductor material other than Y-Ba-Cu-O type compound oxide superconductor material.

Then, this MgO substrate on which the *c*-axis orientated Y₁Ba₂Cu₃O_{7-δ} oxide superconductor thin film was deposited was carried to a vacuum evaporation apparatus which could carry out an ion-beam sputtering process for depositing the SrTiO₃ layer 3.

While the MgO substrate was carried, the surface of the *c*-axis orientated Y₁Ba₂Cu₃O_{7-δ} oxide superconductor thin film was contacted with the air so that the surface of the thin film was degraded and the crystallinity of the surface of the thin film decreased.

In order to restore the crystallinity of the surface of the *c*-axis orientated Y₁Ba₂Cu₃O_{7-δ} oxide superconductor thin film, the MgO substrate was heated under high vacuum. The condition of the heat-treatment was as follows:
- Pressure: Torr x 10⁻⁹ Torr
- Temperature of the substrate: 700°C
- Process time: 3 minutes

After the heat-treatment, the oxide superconductor which composed the oxide superconductor layer 1 was changed into Y₁Ba₂Cu₃O_{6.4} and the crystallinity of the surf:ice of the oxide superconductor thin film was restored.

Then, the MgO substrate allowed to cool to a temperature of 400°C and an SrTiO₃ layer 3 having a thickness of 3 nanometers was deposited on the oxide superconductor layer 1 by an ion-beam sputtering process. The condition of the ion-beam sputtering process was as follows:
- Partial pressure of O₂: 4 x 10⁻⁶ Torr
- Temperature of the substrate: 700°C

This SrTiO₃ layer 3 will be the insulator layer of the Josephson device. The insulator layer can be composed of MgO or YSZ instead of SrTiO₃.

Then, a *c*-axis orientated Y₁Ba₂Cu₃O_{7-δ} oxide superconductor thin film having a thickness of 400 nanometers, which would be the second oxide superconductor layer 2 was deposited on the SrTiO₃ thin film 3 by a laser abrasion process. The condition of the laser abrasion process was as follows:
- Partial pressure of O₂: 10 Torr
- Temperature of the substrate: 700°C

The second oxide superconductor layer 2 was composed of Y₁Ba₂Cu₃O_{6.9} oxide superconductor.

Additionally, the oxide superconductor layers 1 and 2 were composed of *c*-axis orientated oxide superconductor crystals and the SrTiO₃ layer 3 was substantially composed of a single crystal.

Then, as shown in Figures 1B and 1BB, the stacked structure consisting of an oxide superconductor layer 1, an SrTiO₃ layer 3 and a oxide superconductor layer 2 was etched by an Ar ion etching process with a photolithography so that the stacked structure was shaped into a linear shape having a width of 1 µm. As a result, side surfaces of the oxide superconductor layer 1 were exposed.

Thereafter, the MgO substrate 4 on which the linear shaped stacked structure was formed was heated under O₂ atmosphere. The condition of the heat-treatment was as follows:
- Partial pressure of O₂: 10 Torr
- Temperature of the substrate: 400°C
- Process time: 4 hours

During the heat-treatment, oxygen penetrated the oxide superconductor layer 1 from its side surfaces so that the oxide superconductor which composed the oxide superconductor layer 1 was changed into Y₁Ba₂Cu₃O_{6.9} oxide superconductor.

Then, as shown in Figure 1C, an *a*-axis orientated Y₁Ba₂Cu₃O_{7-δ} oxide superconductor thin film 9 having a thickness of 30 nanometers was formed by a sputtering process, so as to cover the linear shaped stacked structure consisting of oxide superconductor layer 1, SrTiO₃ layer 3 and oxide superconductor layer 2. The condition of forming the *a*-axis orientated Y₁Ba₂Cu₃O_{7-δ} oxide superconductor thin film 9 by sputtering was as follows:
- Sputtering Gas: Ar: 90%
O₂: 10%
- Total pressure: 4 x 10⁻² Torr
- Temperature of the substrate: 640°C

An *a*-axis orientated Y₁Ba₂Cu₃O_{7-δ} oxide superconductor thin film can be formed at substrate temperature of about 650°C and under a pressure of 10-50 m Torr.

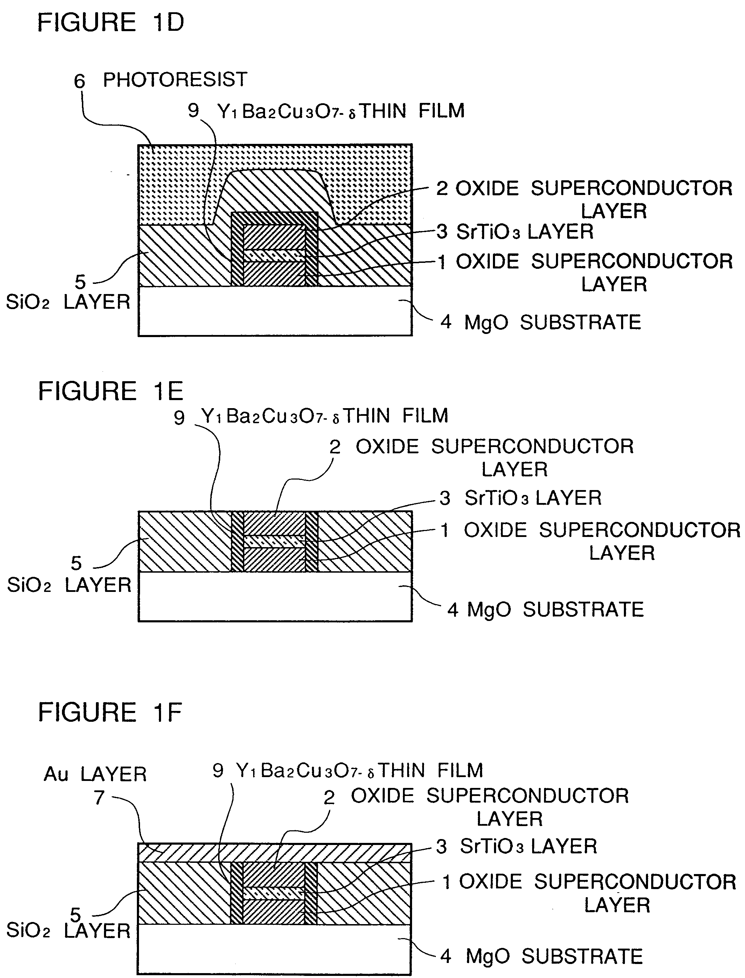

Thereafter, as shown in Figure 1D, an SiO₂ layer 5 having a thickness of 800 nanometers was deposited so as to cover the stacked structure covered with the *a*-axis orientated Y₁Ba₂Cu₃O_{7-δ} oxide superconductor thin film 9 and the exposed portion of the MgO substrate 4. A photoresist layer 6 was deposited on the SiO₂ layer 5 in such a manner that the deposited photoresist layer 6 had a flat upper surface.

Then, as shown in Figure 1E, the photoresist layer 6, the SiO₂ layer 5 and the *a*-axis orientated Y₁Ba₂Cu₃O_{7-δ} oxide superconductor thin film 9 were etched back by a reaction ion etching process, until the upper surface of the SiO₂ layer 5 was planarized and the oxide superconductor layer 2 was exposed at the planarized upper surface of the SiO₂ layer 5.

After the process, an Au layer 7 was deposited on the SiO₂ layer 5 and the oxide superconductor layer 2, as shown in Figure 1F, and a photoresist layer 8 having a width of 1 µm was formed in such a manner that the photoresist layer 8 crossed the linear shaped stacked structure, as shown in Figures 1G and 1GG.

Then, the Au layer 7, the oxide superconductor layer 2, SrTiO₃ layer 3 and the oxide superconductor layer 1 were etched back except the portions under the photoresist layer 8 by an ion milling using Ar-ions, until the thickness of the etched portion of the oxide superconductor layer 1 became about half of the thickness of the nonetched portion of the oxide superconductor layer 1.

Finally, as shown in Figures 1H and 1HH, the etched portion 11 of the oxide superconductor layer was metallized by using Au, and the Josephson device was completed.

The oxide superconductor layers 1 and 2 and the SrTiO₃ of the Josephson device manufactured in accordance with the present invention had high crystallinity which was almost same as single crystal. The oxide superconductor layers 1 and 2 were composed of *c*-axis orientated oxide superconductor thin films and the critical temperatures T_{c} were 90K and 89K.

On the other hand, the oxide superconductor layer 1 of the Josephson device which had some structure as that of the above Josephson device and was manufactured by a conventional method which did not include the heat-treatment in O₂ atmosphere was composed of Y₁Ba₂Cu₃O_{6.4} and did not had superconductivity under liquid nitrogen temperature.

As explained above, if the Josephson device is manufactured in accordance with the method of the present invention, the properties of the oxide superconductor is not spoiled. Accordingly, it is easy to manufacture the Josephson device with good repeatability, and the manufactured Josephson device has a stable performance.

In the above mentioned embodiment, the oxide superconductor thin film can be formed of not only the Y-Ba-Cu-O type compound oxide superconductor material, but also a high-T_{c} (high critical temperature) oxide superconductor material, particularly a high-T_{c} copper-oxide type compound oxide superconductor material, for example a Bi-Sr-Ca-Cu-O type compound oxide superconductor material, and a Tl-Ba-Ca-Cu-O type compound oxide superconductor material.

The invention has thus been shown and described with reference to the specific embodiment. However, it should be noted that the present invention is in no way limited to the details of the illustrated structures but converts and modifications may be made within the scope of the appended claims.

## Claims

1. A method for manufacturing a superconducting device, the method comprising the step of forming on a surface of the substrate a *c*-axis orientated oxide superconductor layer, heating the substrate under high vacuum so as to improve crystallinity of the surface of the *c*-axis orientated oxide superconductor layer, forming on the *c*-axis orientated oxide superconductor layer at least one layer which is not composed of an oxide superconductor, etching the *c*-axis orientated oxide superconductor layer, so that at least one side surface of the *c*-axis orientated oxide superconductor layer exposed, heating the substrate in an O₂ atmosphere, an O₂ atmosphere including O₃ or an O₃ atmosphere, so that oxygen penetrates into the *c*-axis orientated oxide superconductor layer from the exposed side surface, and forming an a-axis orientated oxide superconductor thin film so as to cover the exposed side surface of the *c*-axis orientated oxide superconductor layer.

2. A method claimed in Claim 1 wherein the side surface of the *c*-axis orientated oxide superconductor layer, which is exposed by the etching process is parallel to the *c*-axis of the crystal of the oxide superconductor which composes the *c*-axis orientated oxide superconductor layer.

3. A method claimed in Claim 1 wherein the *c*-axis orientated oxide superconductor layer is etched so that two opposite side surfaces of the *c*-axis orientated oxide superconductor layer are exposed.

4. A method claimed in Claim 3 wherein the *c*-axis orientated oxide superconductor layer is etched so that the distance between the two opposite side surfaces of the *c*-axis orientated oxide superconductor layer is less than about 3 µm.

5. A method claimed in Claim 1 wherein an insulator layer is deposited on the *c*-axis orientated oxide superconductor layer.

6. A method claimed in Claim 5 wherein another *c*-axis orientated oxide superconductor layer is deposited on the insulator layer.

7. A method claimed in Claim 5 wherein the insulator is formed of SrTiO₃ or MgO.

8. A method claimed in Claim 5 wherein the insulator layer is etched with the *c*-axis orientated oxide superconductor layer.

9. A method claimed in Claim 6 wherein the insulator layer and the *c*-axis orientated oxide superconductor layer which is deposited on the insulator layer are etched with the *c*-axis orientated oxide superconductor layer.

10. A method claimed in Claim 1 wherein the substrate is heated at temperatures ranging from 400 to 500°C.

11. A method claimed in Claim 1 wherein the substrate is heated in an O₂ atmosphere of which the partial pressure of O₂ is selected in a range of 5 to 100 Torr.

12. A method claimed in Claim 1 wherein the substrate is heated in an O₃ atmosphere of which the partial pressure of O₃ is selected in a range of 0.1 to 10 Torr.

13. A method claimed in Claim 10 wherein the substrate is heated at a temperature of 400°C in an O₂ atmosphere of which the partial pressure of O₂ is selected in a range of 5 to 20 Torr.

14. A method claimed in Claim 10 wherein the substrate is heated at a temperature of 500°C in an O₂ atmosphere of which the partial pressure of O₂ is selected in a range of 10 to 100 Torr.

15. A method claimed in Claim 10 wherein the substrate is heated at a temperature of 400°C in an O₃ atmosphere of which the partial pressure of O₃ is selected in a range of 0.1 to 1 Torr.

16. A method claimed in Claim 10 wherein the substrate is heated at a temperature of 500°C in an O₃ atmosphere of which the partial pressure of O₃ is selected in a range of 0.2 to 10 Torr.

17. A method claimed in Claim 1 wherein the *a*-axis orientated oxide superconductor thin film is formed so as to have a thickness of 10 to 50 nanometers.

18. A method claimed in Claim 1 wherein the method further includes the step of heating the substrate under high vacuum before a layer is formed on the *c*-axis orientated oxide superconductor layer so as to improve crystallinity of the surface of the *c*-axis orientated oxide superconductor layer.

19. A method claimed in Claim 1 wherein the oxide superconductor is formed of high-T_{c} (high critical temperature) oxide superconductor, particularly, formed of a high-T_{c} copper-oxide type compound oxide superconductor.

20. A method claimed in Claim 1 wherein the oxide superconductor is formed of oxide superconductor material selected from the group consisting of a Y-Ba-Cu-O type compound oxide superconductor material, a Bi-Sr-Ca-Cu-O type compound oxide superconductor material, and a Tl-Ba-Ca-Cu-O type compound oxide superconductor material.

21. A method claimed in Claim 1 wherein the substrate is formed of a material selected from the group consisting of a MgO (100) substrate, a SrTiO₃ (100) substrate and a CdNdAlO₄ (001) substrate.

22. A method for manufacturing a Josephson device, the method comprising the step of forming on a surface of the substrate a first *c*-axis orientated oxide superconductor layer, heating the substrate under high vacuum so as to improve crystallinity of the surface of the first *c*-axis orientated oxide superconductor layer, forming on the *c*-axis orientated oxide superconductor layer a insulator layer, forming on the insulator layer a second *c*-axis orientated oxide superconductor layer, etching the first and second *c*-axis orientated oxide superconductor layer and the insulator layer, so that two opposite side surfaces of the first *c*-axis orientated oxide superconductor layer exposed, heating the substrate in an O₂ atmosphere, an O₂ atmosphere including O₃ or an O₃ atmosphere, so that oxygen penetrates into the first *c*-axis orientated oxide superconductor layer from the exposed side surface, and forming an *a*-axis orientated oxide superconductor thin film so as to cover the exposed side surfaces of the first and second *c*-axis orientated oxide superconductor layer and the insulator layer.
